# EUROPÄISCHE PATENTSCHRIFT

(11) **EP 1 908 099 B1**
(45) Veröffentlichungstag und Bekanntmachung des Hinweises auf die Patenterteilung: **27.07.2011**
(21) Anmeldenummer: 06792997.6
(22) Anmeldetag: 24.08.2006
(51) Int. Cl.: H01L 21/20

(54) **HALBLEITERSUBSTRAT SOWIE VERFAHREN UND MASKENSCHICHT ZUR HERSTELLUNG EINES FREISTEHENDEN HALBLEITERSUBSTRATS MITTELS DER HYDRID-GASPHASENEPITAXIE**
SEMI-CONDUCTOR SUBSTRATE AND METHOD AND MASKING LAYER FOR PRODUCING A FREE-STANDING SEMI-CONDUCTOR SUBSTRATE BY MEANS OF HYDRIDE-GAS PHASE EPITAXY
SUBSTRAT A SEMI-CONDUCTEURS, PROCEDE DE PRODUCTION ASSOCIE, ET COUCHE DE MASQUE DESTINEE A PRODUIRE UN SUBSTRAT A SEMI-CONDUCTEURS ISOLE AU MOYEN D'UNE EPITAXIE D'HYDRURE EN PHASE GAZEUSE

(30) Priorität: 29.08.2005 DE 102005041643
(43) Veröffentlichungstag der Anmeldung: 09.04.2008
(73) Patentinhaber: Freiberger Compound Materials GmbH, 09599 Freiberg (DE)
(72) Erfinder: HENNIG, Christian, 10585 Berlin (DE); WEYERS, Markus, 15745 Wildau (DE); RICHTER, Eberhard, 10318 Berlin (DE); TRAENKLE, Guenther, 12557 Berlin (DE)
(74) Vertreter: Oser, Andreas
(86) Internationale Anmeldenummer: PCT/EP2006/065659
(87) Internationale Veröffentlichungsnummer: WO 2007/025930

(56) Entgegenhaltungen:
- EP-A- 1 439 572
- EP-A- 1 528 590
- US-A1- 2004 183 090

## Beschreibung

Die Erfindung betrifft ein Halbleitersubstrat sowie ein Verfahren und eine Maskenschicht zur Herstellung eines freistehenden Halbleitersubstrats mittels der Hydrid-Gasphasenepitaxie, insbesondere ein Verfahren zur Herstellung von freistehenden Galliumnitrid (GaN)-, Aluminiumnitrid (AlN)- und Aluminiumgalliumnitrid (AlGaN), Indiumnitrid (InN)- und Indiumgalliumnitrid (InGaN)-Substraten mittels der Hydrid-Gasphasenepitaxie (HVPE), bei dem sich die Halbleiterschicht selbständig ohne weitere Prozessschritte vom Substrat (oder auch Ausgangssubstrat bzw. Fremdsubstrat) ablöst. Diese Selbstablösung wird durch laterales epitaktisches Wachstum (ELO, epitaxial lateral overgrowth) über eine Maske erreicht, wobei die Maske mit Öffnungen (Fenstern) versehen ist. In diesen Fenstern liegt vorzugsweise eine dünne Initialschicht (oder auch Startschicht) frei, die vorher auf einem Substrat (wie z: B. Saphir) aufgewachsen wurde. Von diesen Fenstern aus startet das Wachstum. Nach der Koaleszenz der sich dabei bildenden Inseln wächst eine zusammenhängende Halbleiterschicht weiter. Durch die Verspannung zwischen dem Ausgangssubstrat und der aufgewachsenen Schicht kommt es zur Selbstablösung des Halbleitersubstrats, das dann als zusammenhängender Wafer aus dem Reaktor entnommen werden kann. Ein solches Verfahren ist beispielsweise in Applied Physics Leiters, Vol. 85, No. 20, 15. 11. 2004, pp. 4630-4632 bekannt.

Schichtstrukturen aus Gruppe III-Nitriden (Ga, Al, In) sind die Grundlage für eine Vielzahl von modernen Bauelementen für die Hochfrequenzleistungselektronik, z.B. Nachrichtensysteme auf der Basis von HFETs (heterojunction field effect transistor), Sensorik, strahlungsharte Weltraumelektronik und für die Optoelektronik, z.B. UV-, blaue und weiße lichtemittierende Dioden (LEDs) und blaue Laserdioden für Beleuchtungs-, Buchdruck-, Display-, Speicher- und Nachrichtenübertragungsanwendungen sowie medizinische Anwendungen. Solche Schichten werden typischerweise mittels Metallorganischer Gasphasenepitaxie (MOVPE) und auch mittels Molekularstrahlepitaxie (MBE) auf einem Ausgangssubstrat hergestellt.

Ein ideales Ausgangssubstrat soll dem gleichen Materialsystem angehören wie die darauf aufgewachsenen Schichten, beispielsweise ein GaN-Substrat. Dadurch sind von vornherein die Voraussetzungen für ein defektarmes Wachstum, d. h. eine hinreichend gute bis perfekte Gitterfehlanpassung (Homoepitaxie), und die Anpassung der thermischen Ausdehnungskoeffizienten gegeben. Je nach Anwendung ist eine Dotierung vorteilhaft, die das Substrat n-leitend, semiisolierend oder p-leitend macht.

Im Gegensatz zu anderen Halbleitern, z.B. Silizium (Si) und Galliumarsenid (GaAs), gelingt die Herstellung von GaN-Kristallen mit Durchmessern von 5cm (2 Zoll) oder mehr durch klassische Einkristallzüchtung bislang nicht. Klassische Verfahren wie die Züchtung aus der Schmelze unter hohen Drücken und Temperaturen (HPSG - high pressure solution growth) liefern nur Kristallplättchen in der Dimension von cm². Auch die Züchtung durch Sublimation ist bisher nicht erfolgreich. Bisher werden deshalb die Schichtstrukturen meist auf Fremdsubstrate wie z.B. Saphir und Siliziumcarbid (SiC) epitaktisch gewachsen (Heteroepitaxie). Das ist z. B. bezüglich der erzielbaren Versetzungsdichten und der aus unterschiedlichen Gitterkonstanten und Unterschieden in der thermischen Ausdehnung resultierenden Durchbiegung von Nachteil. Diese Durchbiegung führt teilweise auch zu Problemen in der nachfolgenden Prozessierung, da auf durchgebogenen Wafer z. B. die Strukturübertragung mit photolithographischen Verfahren in ihrer Auflösung begrenzt ist.

Folglich wird versucht, GaN-Startsubstrate herzustellen, die auf einem Ausgangssubstrat aufgewachsen und von diesem abgetrennt werden.

Das US Patent 6,740,604 beschreibt ein Verfahren, bei dem nach dem Wachstum einer GaN-Schicht auf einem Ausgangssubstrat diese Schicht mittels Laserstrahlung mit einem weiteren Verfahren abgelöst wird. Hier ist ein weiterer Verfahrensschritt nötig, der aufwändig und in seiner Ausbeute über größere Flächen begrenzt ist. Weiterhin wird mit diesem Verfahren nicht das Problem der Durchbiegung gelöst, da das Paket aus GaN-Schicht und Ausgangssubstrat von Wachstumstemperatur auf Raumtemperatur abgekühlt wird. Die durch die thermische Fehlanpassung induzierte Durchbiegung der Schicht bleibt auch nach Abtrennung vom Ausgangssubstrat teilweise vorhanden.

Das US Patent 6,413,627 beschreibt ein Verfahren auf einem GaAs-Ausgangssubstrat. Dabei wird auf beiden Seiten eines mit einer dielektrischen Maske strukturierten GaAs-Substrats GaN aufgewachsen. Dieses Verfahren erfordert einen aufwändigen Ätzprozess zur Entfernung des GaAs-Substrats, welches darüber hinaus giftig ist. Es kann nur jeweils eine der beiden GaN-Schichten benutzt werden und es ist eine spezielle Apparatur für das beidseitige Wachstum nötig.

Oshima et al. beschreiben ein Verfahren, bei dem eine poröse Schicht aus TiN auf einer GaN-Initialschicht aufgebracht wird, aus deren Poren heraus das Wachstum von GaN startet (Y. Oshima, T. Eri, M. Shibata, H. Sunakawa, K. Kobayashi, T. Ichihashi, A. Usui, Preparation of Freestanding GaN Wafers by Hydride Vapor Phase Epitaxy with Void-Assisted Separation, Jpn. J. Appl. Phys. 42, L1 (2003)). Allerdings ist unklar, wie sich die Porosität dieser TiN-Schicht kontrollieren lässt und ob dieser Prozess reproduzierbar geführt werden kann. Bei dem vorgestellten Verfahren wird die dicke GaN-Schicht durch äußere Krafteinwirkung vom Ausgangssubstrat abgetrennt, was einen zusätzlichen Prozessschritt sowie die dafür nötige Apparatur erfordert. Der Prozess des lateralen epitaktischen Überwachsens (ELO oder ELOG) ist als Möglichkeit der Defektreduzierung aus der WO 99/20816 bekannt. Darin werden dielektrische Maskenmaterialien für den ELOG-Prozess beschrieben.

Dieser Prozess ändert jedoch nichts an der Durchbiegung des Pakets aus Ausgangssubstrat und GaN-Schicht.

Aus der DE 100 11 876 A1 ist die Verwendung einer metallischen Maske bekannt, die in diesem Fall aus Wolfram besteht. Beide Veröffentlichungen verfolgen die Reduktion der Defektdichte durch den ELOG-Prozess. Die Erzeugung eines freistehenden Substrats ist nicht Gegenstand dieser Arbeiten.

Weiterhin ist aus US 4, 868, 633 ein Verfahren zum Aufwachsen von GaAs bekannt, wobei kein laterales Überwachsen einer Vielzahl sockelförmiger Startbereiche, sondern im Gegenteil ein Aufwachsen eines begrenzten Bereiches angestrebt wird. Ein laterales Überwachsen soll gerade verhindert werden. Dazu wird eine WSi:Zn-Maske verwendet, wobei die WSi:Zn-Maske ein laterales Überwachsen vermeiden soll. In Fig. 1 und 2 der US 4, 868, 633 (mit dazugehörigem Text) wird untersucht, wie GaAs im Bereich des Sockels und dessen Umgebung aufgewachsen werden kann. Ist die Konzentration von W in der obersten Schicht einer WSi-Maske groß, wird eine Inselbildung unterdrückt. Ist dagegen die Konzentration von Si in der obersten Schicht der WSi-Maske groß, kann sich auf der WSi-Maske eine Schicht aus polykristallinem GaAs ausbilden. Da man jedoch die Ausbildung einer GaAs-Schicht auf der WSi-Maske verhindern will, wird die WSi-Maske mit Zink dotiert.

Weiterhin ist in Materials Science and Engineering: B, Vol. 82, No. 1, 22. 05. 2001, pp. 62-64 (3) (Abstract) die Verwendung von WNₓ Masken zur Herstellung/Behandlung von GaN Schichten offenbart, wobei die WNₓ Maske anstatt der W Maske verwendet wird, um eine Ablösung einer GaN Schicht zu vermeiden.

Die US 6,146,457 beschreibt ein Verfahren, bei dem eine Halbleiterschicht mittels Gasphasenepitaxie auf eine Wachstumsunterlage bestehend aus einem Si-, SiC- oder Saphir-Substrat und einer dünnen Zwischenschicht abgeschieden wird, wobei es bei der anschließenden Abkühlung auf Grund unterschiedlicher thermischer Ausdehnungskoeffizienten von Halbleiterschicht und Substrat zur Generierung von Defekten im Substrat und nicht in der Epitaxieschicht kommt und dabei eine hochqualitative Halbleiterschicht verhalten wird. Als mögliche Materialien für die Zwischenschicht werden in Anspruch 3 explizit Siliziumoxid, - nitrid oder -carbid aufgeführt. Laut Anspruch 4 kann die Zwischenschicht auch strukturiert sein, wobei das ELOG-Verfahren zur Reduzierung der Defektdichte weder beschrieben noch erwähnt wird. Des weiteren wird weder in den Ansprüchen noch in den Ausführungsbeispielen explizit ein freistehendes Halbleitersubstrat als Ergebnis des Verfahrens erwähnt.

Es ist daher Aufgabe der vorliegenden Erfindung, ein Verfahren zur Herstellung einer freistehenden (also nicht an ein Substrat gebundenen) Halbleiterschicht, vorzugsweise aus Galliumnitrid (GaN)-, Aluminiumnitrid (AIN), Aluminiumgalliumnitrid (AlGaN), Indiumnitrid (InN) oder Indiumgalliumnitrid (InGaN) anzugeben, welches möglichst wenige Prozessschritte benötigt und welches zudem die Herstellung einer planen, nicht oder nur gering durchgebogenen Halbleiterschicht ermöglicht. Weiterhin soll ein freistehendes Substrat angegeben werden, welches kostengünstig herstellbar ist und eine sehr gute Planarität aufweist.

Diese Aufgaben werden erfindungsgemäß durch ein Verfahren mit den Merkmalen des Patentanspruchs 1, durch ein Substrat mit den Merkmalen des Patentanspruchs 18, sowie die Verwendung einer Maskenschicht des Anspruchs 21 gelöst. Bevorzugte Ausgestaltungen sind in den Unteransprüchen enthalten.

Das erfindungsgemäße Verfahren zur Herstellung eines Halbleitersubstrats ist durch folgende Verfahrensschritte gekennzeichnet:
- Bereitstellen eines Ausgangssubstrats,
- Aufbringen einer Maskenschicht mit einer Vielzahl von Öffnungen auf dem Ausgangssubstrat, wobei die Maskenschicht struckturiert wird, entweder litographisch und öffnen von Fenstern durch nass- oder trocken chemische Ätzverfahren, oder durch ein Lift-off-Verfahren
- Aufwachsen mindestens eines Halbleitersubstrats ausgehend von Öffnungen wobei die Maskenschicht von mindestens einem Halbleitermaterial lateral überwachsen wird, und anschließendem
- Abkühlen von Ausgangssubstrat, Maskenschicht und Halbleitersubstrat, wobei das Material zur Ausbildung der Maskenschicht zumindest teilweise aus Wolframsilizidnitrid oder Wolframsilizid besteht, wobei es während des Wachstums oder erst beim Abkuhlen zu einer Trennung von Halbleitersubstrat und Ausgangssubstrat kömmt und ein Halbleitersubstrat freistehend erhalten wird, wobei das Halbleitersubstrat mindestens einen Nitrid-Verbindungshalbleiter enthält.

Vorzugsweise besteht das Material zur Ausbildung der Maskenschicht vollständig aus Wolframsilizidnitrid oder vollständig aus Wölframsilizid. Vorzugsweise ist die Maskenschicht aus Wolframsilizidnitrid oder aus Wolframsilizid nicht mit anderen Stoffen dotiert.

Besonders bevorzugt ist Wolframsilizidnitrid. Vorzugsweise wird vor dem Aufbringen der Maskenschicht eine kontinuierliche Initialschicht auf das Substrat aufgewachsen und die Maskenschicht auf die Initialschicht aufgebracht. Es besteht auch alternativ die Möglichkeit, ohne Initialschicht die Maskenschicht direkt auf das Substrat aufzubringen, was insbesondere für SiC-Substrate vorteilhaft ist.

Die strukturierte Maskenschicht wird vorzugsweise durch Aufbringen einer kontinuierlichen Maskenschicht mittels Sputtern oder Gasphasenabscheidung und nachfolgendes Einbringen einer Vielzahl von Öffnungen hergestellt. Vorzugsweise werden die Öffnungen trockenchemisch mittels Plasmaätzen in die Maskenschicht eingebracht. Alternativ sind auch nasschemisches Ätzen oder ein Lift-off-Prozess möglich.

Auf die derart strukturierte Maskenschicht wird ausgehend von den Öffnungen mindestens eine erste Halbleiterschicht, die Koaleszenzschicht, aus Halbleitermaterial aufgewachsen, die das Maskenmaterial vollkommen bedeckt und eine kontinuierliche Schicht bildet.

Vorzugsweise enthält die Initialschicht einen Nitrid-Verbindungshalbleiter, besonders bevorzugt eine Nitrid-Verbindung von Elementen der dritten und/oder fünften Hauptgruppe, besonders bevorzugt GaN, AIN, AlGaN, InN, InGaN, AlInN oder AlInGaN.

Auf die erste Halbleiterschicht kann eine weitere Halbleiterschicht vorzugsweise im gleichen Wachstumsprozess aufgebracht werden. Die Dicke beträgt bevorzugt mehr als 50 µm, noch bevorzugter mehr als 200 µm. Alternativ kann die erste Halbleiterschicht auch in einem ersten Wachstumsprozess erzeugt und in einem zweiten Wachstumsprozess ganzflächig mit der zweiten Halbleiterschicht überwachsen werden. Vorzugsweise enthält auch diese zweite Halbleiterschicht einen Nitrid-Verbindungshalbleiter, besonders bevorzugt eine Nitrid-Verbindung von Elementen der dritten und/oder fünften Hauptgruppe, besonders bevorzugt GaN, AIN, InN, InGaN, AlGaN, AlInN oder AlInGaN.

Vorzugsweise enthält das Ausgangssubstrat Siliziumkarbid oder Saphir. Vorzugsweise werden auf die so hergestellte Halbleiterschicht weitere, insbesondere einen Nitrid-Verbindungshalbleiter enthaltende Halbleiterschichten oder ein metallischer Kontakt zur Ausbildung eines elektronischen oder optoelektronischen Bauelements aufgebracht.

Das freistehende Halbleitersubstrat entsteht bevorzugt durch Rissbildung an der Grenzfläche zum Ausgangssubstrat sowie in den Bereichen des Halbleitersubstrats innerhalb der Öffnungen der Maske auf Grund der tensilen Verspannung während des Wachstums oder der unterschiedlichen thermischen Ausdehnungskoeffizienten von Ausgangssubstrat und mindestens einem Halbleitersubstrat beim Abkühlen.

Das erfindungsgemäße Halbleitersubstrat zur Herstellung elektronischer oder optoelektronischer Bauelemente weist einen Nitrid-Verbindungshalbleiter auf (vorzugsweise GaN, AIN, AlGaN, InN, InGaN, AlInN oder AlInGaN), wobei das Halbleitersubstrat gemäß der Erfindung Spuren von Wolframsilizidnitrid oder Spuren von Wolframsilizid oder Spuren von Silizium und Wolfram aufweist. Die Konzentration der Spuren richtet sich nach der Nachweisbarkeitsgrenze für solche Rückstände nach der Ablösung. Sie betragen bevorzugt mehr als 10¹⁵ Atome je cm³. Es ist aber nicht auszuschließen, dass mit dem erfindungsgemäßen Verfahren auch ein Halbleitersubstrat hergestellt werden kann, an dem die genannten Spuren nicht nachweisbar sind.

Das Verfahren ermöglicht die Herstellung von defektreduzierten, freistehenden GaN-Wafern, die sich selbständig vom Ausgangssubstrat ablösen. Diese Ablösung kann aufgrund der bei zunehmender Schichtdicke auch zunehmenden tensilen Verspannung der aufgewachsenen Halbleiterschicht bereits während des Wachstums stattfinden oder aber spätestens durch die unterschiedlichen thermischen Ausdehnungskoeffizienten beim Abkühlen von Wachstumstemperatur erfolgen. Es wurde gefunden, dass eine solche Ablösung insbesondere bei Verwendung von Wolframsilizidnitrid oder Wolframsilizid als Maskenmaterial erfolgt. Dadurch kann auf einen zusätzlichen Technologieschritt zur Ablösung verzichtet werden. Durch die Ablösung bereits bei hohen Temperaturen weisen die GaN-Wafer nur eine geringe bzw. keine Durchbiegung auf, was für die weitere Prozessierung von Vorteil ist.

Daher besteht die erfindungsgemäße Maskenschicht zur Herstellung eines Halbleitersubstrats zumindest teilweise aus Wolframsilizidnitrid. Bevorzugt besteht sie vollständig aus Wolframsilizidnitrid. Vorzugsweise ist die Maskenschicht aus Wolframsilizidnitrid nicht mit anderen Stoffen dotiert.

Vorzugsweise wird eine geeignete Initialschicht verwendet, auf der das epitaktische Wachstum der Halbleiterschicht(en) (beispielsweise von GaN) möglich ist. Diese Initialschicht besteht vorzugsweise aus einer wenige µm dicken GaN-Schicht, die heteroepitaktisch auf einem Ausgangssubstrat abgeschieden wurde. Als Ausgangssubstrate für das Wachstum von GaN wurden bereits Saphir, SiC, Si und GaAs demonstriert. Als Verfahren zur Herstellung der Initialschicht kann jede Technologie verwendet werden, die eine geschlossene GaN-Schicht auf dem Ausgangssubstrat abscheidet. Weit verbreitete Verfahren hierfür sind MOVPE, HVPE und MBE. Alternativ kann die Initialschicht aus AIN, AlGaN, InN, InGaN, AlInN oder AlInGaN bestehen. Vorzugsweise besteht sie aus dem Material der nachfolgend aufgebrachten ersten Halbleiterschicht, der Koaleszenzschicht. Beim Wachstum auf SiC wird vorzugsweise auf diese Startschicht verzichtet.

Bei Verwendung einer Initialschicht wird eine dünne Maskenschicht abgeschieden, die zumindest teilweise aus Wolframsilizid (WSi) oder Wolframsilizidnitrid (WSiN) besteht. Ohne Initialschicht würde die Maskenschicht direkt auf das Substrat abgeschieden werden. ELOG-Masken haben typischerweise eine Dicke zwischen 50 und 200 nm. Die abgeschiedene WSi- oder vorzugsweise WSiN-Schicht wird lithographisch strukturiert und es werden Fenster durch nass- oder trockenchemische Ätzverfahren geöffnet, in denen die Initialschicht bzw. das Substrat (SiC-Substrat) frei liegt. Zur Strukturierung sind auch andere Verfahren denkbar, wie etwa ein sogenanntes Lift-off-Verfahren. Diese in der Halbleitertechnologie gängigen Strukturierungsverfahren erlauben eine definierte und reproduzierbare Herstellung der Öffnungen in den Maskierungsschichten. Vorzugsweise sind diese Öffnungen meistens periodisch angeordnet, weisen eine runde oder vieleckige Geometrie auf oder bestehen aus parallel angeordneten Streifen.

Ebenfalls möglich ist der Einsatz einer porösen WSiN-Schicht ohne nachfolgenden Strukturierungsschritt. Hierbei ist aber die Reproduzierbarkeit des Prozessergebnisses sicherzustellen.

Auf die maskierte Initialschicht oder das maskierte Substrat wird anschließend mittels Gasphasenepitaxie eine mindestens 50 µm dicke GaN/AlGaN-Schicht (oder eine andere Nitridhalbleiterschicht) aufgewachsen. Hierbei wächst das Material vertikal aus den Fenstern und lateral über der Maske, bis die Wachstumsfronten koaleszieren und wieder eine glatte Schicht bilden. Diese erste Halbleiterschicht haftet erfindungsgemäß nicht auf der beschriebenen Maskierungsschicht aus WSiN, was wesentliche Voraussetzung für die nachfolgende Selbstablösung ist. Die Verbindung zum Ausgangssubstrat wird ausschließlich durch die geöffneten Fenster (Öffnungen) in dieser Maskierungsschicht hergestellt.

Bei der Wahl von SiC als Ausgangsubstrat kann auf die Aufbringung einer GaN-Initialschicht verzichtet werden. Die WSiN-Maskierungsschicht wird direkt auf das Ausgangssubstrat aufgebracht und strukturiert. Anschließend wird mittels ELO eine geschlossene erste Halbleiterschicht, die Koaleszenzschicht, aus GaN, AIN oder AlGaN oder einem anderen Nitridhalbleiter aufgewachsen. Auf diese Koaleszenzschicht kann unmittelbar nachfolgend im gleichen Epitaxieprozess oder alternativ in einem weiteren Epitaxieprozess ganzflächig eine zweite, dicke Halbleiterschicht aus einem Nitridhalbleiter, vorzugsweise mit einer Dicke größer als 50 µm, aufgewachsen werden.

Bei geeigneter Wahl der Maskengeometrie, der Abscheidungsparameter und der Prozessführung trennt sich die aufgewachsene zweite dicke Halbleiterschicht zusammen mit der ersten Halbleiterschicht, der Koaleszenzschicht, ganzflächig vom Ausgangssubstrat ab und es entsteht ein freistehender Wafer von z.B. 5 cm (2 Zoll) Durchmesser. Dieser Wafer kann dann zum Wachstum von Schichtstrukturen für Bauelemente oder als Keim für das Wachstum von Volumenkristallen aus GaN, AIN oder AlGaN oder einem anderen Nitridhalbleiter eingesetzt werden, wobei ggf. vorher noch Prozessschritte zur Glättung der Oberflächen (Polieren, Ätzen) durchgeführt werden können.

Die Erfindung wird nachstehend in Ausführungsbeispielen anhand von Figuren näher erläutert. Es zeigen:
- Fig. 1: das bereitgestellte Ausgangssubstrat 1 mit einer Initialschicht 1a in schematischer, geschnittener Darstellung,
- Fig. 2: das Ausgangssubstrat mit Maskenschicht 2 (nach Aufbringen der Maskenschicht) sowie den Öffnungen 3 in schematischer, geschnittener Darstellung,
- Fig. 3: das Ausgangssubstrat nach Aufbringen der Maskenschicht 2 in Draufsicht mit den Öffnungen 3,
- Fig. 4: das Ausgangssubstrat mit Maskenschicht während der Aufwachsens der lateral überwachsenden ersten Halbleiterschicht 4 als Koaleszenzschicht in schematischer, geschnittener Darstellung,
- Fig. 5: das Ausgangssubstrat mit Maskenschicht nach dem Aufwachsen der ersten Halbleiterschicht 4 als Koaleszenzschicht, die eine geschlos- sene Schicht bildet, in schematischer, geschnittener Darstellung,
- Fig. 6: das Ausgangssubstrat nach dem ganzflächigen Überwachsen der mindesten einen ersten Halbleiterschicht 4 mit einer zweiten, dicken Halbleiterschicht 5,
- Fig. 7: das durch Selbstablösung vom Ausgangssubstrat abgelöste erfindungsgemäße Halbleitersubstrat 6 mit erster Halbleiterschicht 4,
- Fig. 8: das durch Selbstablösung vom Ausgangssubstrat abgelöste erfindungsgemäße Halbleitersubstrat 6, wobei die ersten und zweiten Halbleiterschichten 4, 5 aus dem selben Material ausgebildet sind.

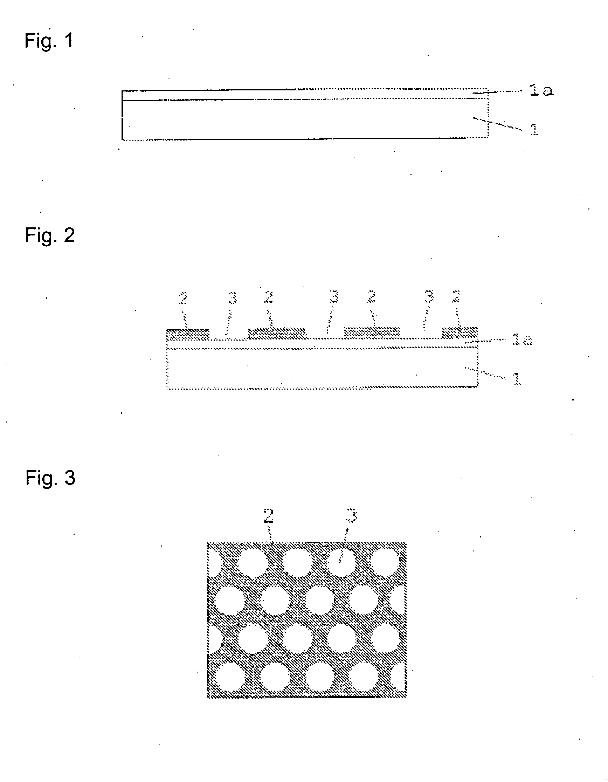

In einem ersten Ausführungsbeispiel wird ein Ausgangssubstrat 1 (c-plane Saphirwafer, Durchmesser 2 Zoll bzw. 50,8 mm) mittels MOVPE mit einer 2 µm dicken Initialschicht 1a aus GaN bewachsen (Fig. 1). Anschließend wird diese Initialschicht 1a ganzflächig mit einer 100 nm dicken, gesputterten Maskenschicht 2 (WSiN-Schicht) bedeckt (Fig. 2). Diese Schicht 2 wird mittels Lithographie und nachfolgendem Ätzprozess derart strukturiert, dass hexagonal angeordnete runde Öffnungen 3 (Fenster) entstehen (Fig. 3). Im Beispiel werden hexagonal angeordnete runde Fenster (Öffnungen 3) mit 10 µm Durchmesser und einem Abstand der Mittelpunkte benachbarter Fenster von 15 µm benutzt.

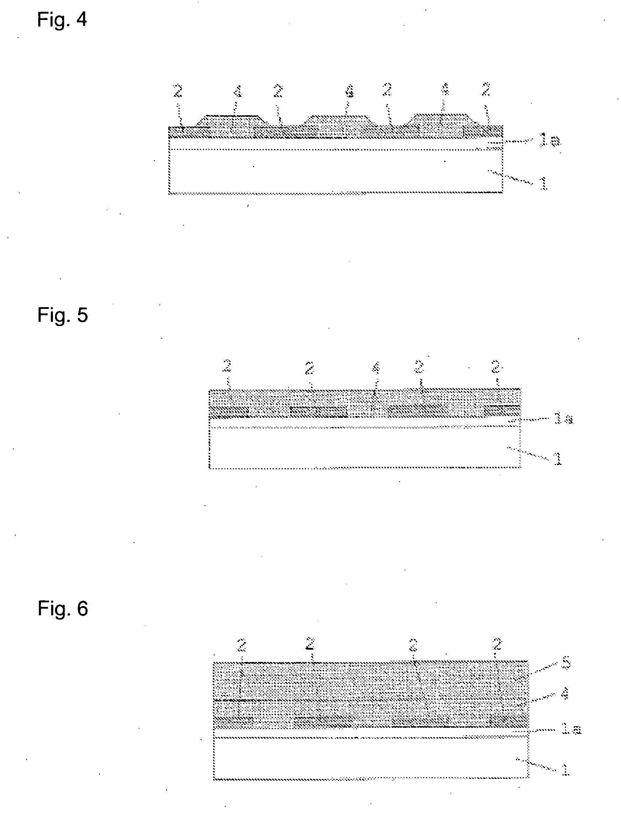

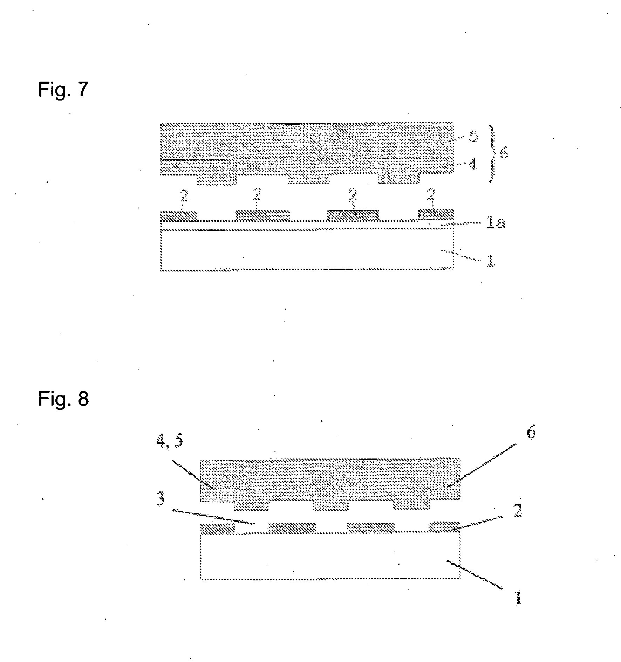

Auf dem so strukturierten Ausgangssubstrat wird dann zuerst eine erste Halbleiterschicht 4 als Koaleszenschicht aus GaN aufgewachsen (Fig. 4 und Fig. 5) . Dazu wird das mit der Maskenschicht 2 und den Öffnungen 3 strukturierte Ausgangssubstrat 1 mit der Initialschicht 1a in einem horizontalen HVPE-Reaktor auf 1040°C aufgeheizt, wobei ab 750°C die Oberfläche mit Ammoniak stabilisiert wird. Das Wachstum findet bei 800 hPa Reaktordruck und einer Temperatur von 1040°C sowie einem V/III-Verhältnis von 5 statt. Die Wachstumsrate für ganzflächiges Wachstum beträgt dabei 150 µm/h. Nach 5 Minuten ist die erste Halbleiterschicht 4 als Koaleszenzschicht geschlossen und hat eine mittlere Dicke von etwa 10 - 15 µm. Anschließend wird die geschlossene erste Halbleiterschicht 4, die Koaleszenzschicht, mit einer zweiten Halbleiterschicht 5 einer Dicke oberhalb von 100 µm überwachsen, wobei Dicken oberhalb 200 µm vorteilhaft sind (Fig. 6). Im Ausführungsbeispiel weist die Halbleiterschicht eine Dicke von 450 µm auf. Die beim Wachstum auftretende Verspannung zwischen Ausgangssubstrat 1 und aufgewachsenem Halbleitersubstrat 6, bestehend aus der ersten Halbleiterschicht 4, der Koaleszenzschicht, und der zweiten Halbleiterschicht 5, bewirkt bei der dargestellten Prozessführung und Maskengeometrie die Abtrennung des gewachsenen Halbleitersubstrats 6 vom darunter befindlichen Ausgangssubstrat 1, wie in Fig. 7 gezeigt ist. Beim Abkühlen mit einer Rate von ca. 300°C/h wird wiederum bis zu einer Temperatur von 750°C die Oberfläche mit Ammoniak stabilisiert. Nach Ende des Prozesses kann das abgelöste Halbleitersubstrat 6, hier als GaN-Schichtpaket, von ca. 460 µm Dicke aus dem Reaktor entnommen werden.

In einem zweiten Ausführungsbeispiel wird ein Ausgangssubstrat 1 (c-plane Saphirwafer, Durchmesser 50,8 mm) mittels MOVPE mit einer 2 µm dicken GaN-Initialschicht 1a bewachsen (Fig. 1). Anschließend wird diese Initialschicht ganzflächig mit einer 100 nm dicken gesputterten Maskenschicht 2 (WSiN-Schicht) bedeckt (Fig. 2). Diese Schicht wird mittels Lithographie und nachfolgendem Ätzprozess derart strukturiert, dass parallel verlaufende Streifen (Öffnungen 3) entstehen. Es wird demzufolge eine Streifenmaske verwendet.

Der so strukturierte Ausgangswafer 1, 2 wird dann mittels MOVPE so mit GaN überwachsen, dass die aus den Fenstern herauswachsenden Inseln koaleszieren (Fig. 4/5). Nach erfolgter Koaleszenz wird auf der entstandenen zusammenhängenden GaN-Schicht 4 mit einem Verfahren, das geeignet hohe Wachstumsraten erlaubt, z.B. mittels der HVPE, eine Schicht 5 aus GaN, AIN oder AlGaN mit einer Dicke oberhalb von 50 µm aufgewachsen, wobei Dicken oberhalb 200 µm vorteilhaft sind (Fig. 6). Die beim Wachstum auftretende Verspannung zwischen Ausgangssubstrat 1 und aufgewachsenem Halbleitersubstrat 6 bewirkt bei geeigneter Prozessführung und Maskengeometrie die Abtrennung der gewachsenen Schicht vom darunter befindlichen Ausgangssubstrat, wie in Fig. 7 gezeigt ist.

In einem dritten Ausführungsbeispiel wird ein Ausgangssubstrat 1 aus SiC verwendet und auf die vorherige Aufbringung einer Initialschicht 1a verzichtet. Der SiC-Wafer 1 wird direkt mit der 100 nm dicken gesputterten Maskenschicht 2 (WSiN-Schicht) bedeckt. Diese Schicht 2 wird mittels Lithographie und nachfolgendem Ätzprozess derart strukturiert, dass hexagonal angeordnete runde Öffnungen 3 (Fenster) entstehen (Fig. 3).

Der so strukturierte Ausgangswafer 1, 2 wird dann mittels MOVPE so mit GaN überwachsen, dass die aus den Fenstern herauswachsenden Inseln koaleszieren. Nach erfolgter Koaleszenz wird auf der entstandenen zusammenhängenden GaN-Schicht 4 mit einem Verfahren, das geeignet hohe Wachstumsraten erlaubt, z.B. mittels der HVPE, eine zweite Halbleiterschicht 5 aus GaN, AIN oder AlGaN mit einer Dicke oberhalb von 50 µm aufgewachsen, wobei Dicken oberhalb 200 µm vorteilhaft sind. Die beim Wachstum auftretende Verspannung zwischen Ausgangssubstrat 1 und dem aufgewachsenen Halbleitersubstrat 6 - bestehend aus der ersten Halbleiterschicht 4, der Koaleszenzschicht, und der dicken, zweiten Halbleiterschicht 5 - sowie die bei Temperaturänderung, insbesondere bei Abkühlung von Wachstumstemperatur, eingebrachte thermische Verspannung bewirken bei geeigneter Prozessführung und Maskengeometrie die Abtrennung der gewachsenen Schicht 6 vom darunter befindlichen Ausgangssubstrat 1.

Die aufgewachsenen ersten Halbleiterschichten 4 und zweiten Halbleiterschichten 5 können dabei aus dem selben Material oder aus unterschiedlichen Materialien bestehen. Die Halbleiterschichten 4 und 5 können in gleichen Wachstumsprozess oder in verschiedenen Wachstumsprozessen aufgewachsen werden. Das Halbleitersubstrat 6 kann auch allein aus einer ersten Halbleiterschicht 4 bestehen.

Fig. 8 zeigt ein erfindungsgemäßes Halbleiterschichtsubstrat 6, bei dem die zweite Halbleiterschicht 5 aus dem selben Material wie die erste Halbleiterschicht 4, die Koaleszenzschicht, besteht. Auf eine Initialschicht 1a wurde hier verzichtet. Die zweite Halbleiterschicht wurde hier im gleichen Wachstumsprozess aufgebracht. Daher sind die Halbleiterschichten 4 und 5 ineinanderübergehend.

Bevorzugt wird die mindestens eine erste Halbleiterschicht 4 mit einer Dicke von 1 bis 50 µm aufgewachsen. Noch bevorzugter wird die mindestens eine erste Halbleiterschicht 4 mit einer Dicke von 10 bis 30 µm aufgewachsen.

Die zweite Halbleiterschicht 5 wird bevorzugt mit einer Dicke von mehr als 100 µm, noch bevorzugter von mehr als 200 µm aufgewachsen.

Bei allen drei Ausführungsbeispielen können die aufgewachsenen GaN-, AIN- und AlGaN-Schichten durch die Einbringung geeigneter Dotanden gezielt p- und n-dotiert oder auch semiisolierend gemacht werden. Eine n-Dotierung des wachsenden Gruppe III-Nitrids kann durch die Reaktion von Silizium mit Chlorwasserstoffgas oder besonders einfach durch die Zugabe der siliziumhaltigen Verbindung Dichlorsilan (Cl₂SiH₂) erreicht werden.

Eine p-Dotierung des wachsenden Gruppe III-Nitrids kann durch die Reaktion von Magnesium Mg mit Chlorwasserstoffgas oder durch die Zugabe einer magnesiumhaltigen Verbindung, als Surfactant oder zum Einbau in die Schicht, z. B. Biscyclopentadienylmagnesium (Cp₂Mg: Mg(C₅H₅)₂), in die Gasphase erreicht werden. In ähnlicher Weise kann auch Indium als Surfactant eingesetzt werden.

Eine Dotierung des wachsenden Gruppe III-Nitrids zur Erzielung semiisolierender elektrischer Eigenschaften kann durch die Reaktion von Eisen (Fe) mit Chlorwasserstoffgas oder durch die Zugabe einer eisenhaltigen Verbindung, z.B. Biscyclopentadienyleisen (Ferrocen: Cp₂Fe: Fe(C₅H₅)₂), in die Gasphase erreicht werden.

Die Verwendung eines Dotiergases gegenüber einer Feststoffquelle vereinfacht das Verfahren, da ein Dotiergas kontinuierlich gesteuert werden kann. Wenn erfindungsgemäβ Wolframsilizidnitrid als Maskenmaterial verwendet wird, kann das freistehende Halbleitersubstrat 6, welches nach obigem Verfahren hergestellt wurde, nach der Ablösung Spuren von Wolframsilizidnitrid aufweisen. Bevorzugt liegen die Spuren im Bereich von mehr als 10¹⁵ Atome je cm³ oder 1/10 einer Monolage oder größer. Dieser Wert richtet sich nach der Nachweisbarkeitsgrenze der Spuren. Bevorzugt liegen die Spuren im Bereich von weniger als 200 nm.

Die erfindungsgemäßverwendete 2 für die Herstellung eines freistehenden Halbleitersubstrats 6 auf einem Ausgangssubstrat 1 besteht zumindest teilweise aus Wolframsilizidnitrid oder Wolframsilizid. Bevorzugt besteht die Maskenschicht 2 vollständig aus Wolframsilizidnitrid oder Wolframsilizid.

Die erhaltene freistehende Halbleiterschicht aus GaN, AIN, AIGaN, InN, InGaN, AlInN oder AlInGaN kann als Substrat (Nitrid-Substrat) für das Wachstum von Gruppe III-Nitrid-Schichtstrukturen in der MOVPE oder in der MBE oder durch die Aufbringung metallischer Kontakte zur Herstellung von elektronischen oder optoelektronischen Bauelementen weiterverwendet werden. Dazu kann die Oberfläche poliert werden. Das Nitrid-Substrat kann auch als Initialschicht für das weitere Wachstum von Gruppe III-Nitriden mit der HVPE genutzt werden.

Die Erfindung beschränkt sich nicht auf die hier dargestellten Ausführungsbeispiele. Vielmehr ist es möglich, durch Kombination und Modifikation der genannten Mittel und Merkmale weitere Ausführungsvarianten zu realisieren, ohne den Rahmen der Erfindung zu verlassen.

### Bezugszeichenliste

- 1: Ausgangssubstrat
- 1a: Initialschicht
- 2: Maskenschicht
- 3: Öffnung
- 4: Erste Halbleiterschicht, Koaleszenzschicht
- 5: Zweite Halbleiterschicht, dicke Halbleiterschicht
- 6: Halbleitersubstrat

## Patentansprüche

1. Verfahren zur Herstellung eines Halbleitersubstrats (6) mit folgenden Verfahrensschritten:
a) Bereitstellen eines Ausgangssubstrats (1),
b) Aufbringen einer Maskenschicht (2) mit einer Vielzahl von Öffnungen (3) auf dem Ausgangssubstrat (1), wobei die Maskenschicht strukturiert wird, entweder lithographisch und öffnen von Fenstern durch nass- oder trockenchemische Ätzverfahren, oder durch ein Lift-off-Verfahren,
c) Aufwachsen mindestens eines Halbleitersubstrats (6) ausgehend von den Öffnungen (3), wobei die Maskenschicht (2) von mindestens einem Halbleitermaterial lateral überwachsen wird, und anschließendem
d) Abkühlen von Ausgangssubstrat (1), Maskenschicht (2) und Halbleitersubstrat (6),
wobei das Material zu Ausbildung der Maskenschicht (2) zumindest teilweise aus Wolframsilizidnitrid oder Wolframsilizid besteht, und es während des Wachstums oder während des Abkühlens zu einer Trennung von Halbleitersubstrat (6) und Ausgangssubstrat (1) kommt und ein Halbleitersubstrat (6) freistehend erhalten wird, wobei das Halbleitersubstrat (6) mindestens einen Nitrid-Verbindungshalbleiter enthält.

2. Verfahren nach Anspruch 1, **dadurch gekennzeichnet, daß** das Material zur Ausbildung der Maskenschicht (2) vollständig aus Wolframsilizidnitrid oder vollständig aus Wolframsilizid besteht.

3. Verfahren nach Anspruch 1 oder 2, **dadurch gekennzeichnet, daß** das freistehende Halbleitersubstrat (6) durch Rissbildung im Ausgangssubstrat (1) sowie in den Bereichen des Halbleitersubstrats (6) innerhalb der Öffnungen (3) der Maske (2) auf Grund der unterschiedlichen thermischen Ausdehnungskoeffizienten von Ausgangssubstrat (1) und dem mindestens einen Halbleitersubstrat (6) während des Abkühlens oder auf Grund der tensilen Verspannung der aufgewachsenen Halbleiterschicht während des Wachstums entsteht.

4. Verfahren nach mindestens einem der Ansprüche 1 bis 3, **dadurch gekennzeichnet, daß** im Schritt c) mindestens eine erste Halbleiterschicht (4) als Koaleszenzschicht aufgewachsen wird, wobei die Maskenschicht (2) von dem Halbleitermaterial (4) lateral überwachsen wird, bis sich eine geschlossene Schicht bildet, so dass das Halbleitersubstrat (6) aus der mindestens einen ersten Halbleiterschicht (4) besteht.

5. Verfahren nach Anspruch 4, **dadurch gekennzeichnet, daß** im Schritt c) auf die mindestens eine erste Halbleiterschicht (4) mindestens eine zweite Halbleiterschicht (5) aufgewachsen wird, so dass das Halbleitersubstrat (6) aus der mindestens einen ersten Halbleiterschicht (4) und der mindestens einen zweiten Halbleiterschicht (5) besteht.

6. Verfahren nach Anspruch 4, **dadurch gekennzeichnet, dass** die mindestens eine erste Halbleiterschicht (4) mit einer Dicke von 1 bis 50 µm aufgewachsen wird.

7. Verfahren nach Anspruch 5, **dadurch gekennzeichnet, dass** die mindestens eine zweite Halbleiterschicht (5) mit einer Dicke von mehr als 100 µm aufgewachsen wird.

8. Verfahren nach einem der vorhergehenden Ansprüche, **dadurch gekennzeichnet, daß** vor Schritt b) ganzflächig mindestens eine Initialschicht (1a), bestehend aus einer oder mehrerer Einzelschichten, auf das Ausgangssubstrat (1) aufgewachsen wird und die Maskenschicht (2) auf die mindestens eine Initialschicht (1a) aufgebracht wird.

9. Verfahren nach einem der vorhergehenden Ansprüche 5, 7 oder 8 **dadurch gekennzeichnet, daß** die mindestens eine zweite Halbleiterschicht (5) und/oder die mindestens eine Initialschicht (1a) mindestens einen Nitrid-Verbindungshalbleiter enthält.

10. Verfahren nach einem der Ansprüche 4 bis 9, **dadurch gekennzeichnet, daß** der in der mindestens einen ersten Halbleiterschicht (4) enthaltene und/oder der mindestens einen zweiten Halbleiterschicht (5) enthaltene und/oder in der mindestens einen Initialschicht (1a) enthaltene mindestens eine Nitrid-Verbindungshalbleiter eine Nitrid-Verbindung von Elementen der dritten und/oder fünften Hauptgruppe ist.

11. Verfahren nach Anspruch 10, **dadurch gekennzeichnet, daß** die mindestens eine Nitrid-Verbindung GaN, AIN, AlGaN, InN, InGaN, AlInN oder AlInGaN ist.

12. Verfahren nach einem der vorhergehenden Ansprüche, **dadurch gekennzeichnet, daß** die mindestens eine erste Halbleiterschicht (4) mittels Hydrid-Gasphasenepitaxie aufgewachsen wird.

13. Verfahren nach einem von den Ausprüchen 8 bis 10 abhängigen Ansprüche, **dadurch gekennzeichnet, daß** die mindestens eine erste Halbleiterschicht (4) durch Überwachsen der Initialschicht (1a) mittels lateralem epitaktischen Überwachsen (ELOG) aufgebracht wird.

14. Verfahren nach einem der vorhergehenden Ansprüche, **dadurch gekennzeichnet, daß** die mindestens eine erste Halbleiterschicht derart aufgewachsen wird, dass die aus den Öffnungen (3) wachsenden Inseln koalesziert sind und sich eine geschlossene Oberfläche gebildet hat.

15. Verfahren nach einem der vorhergehenden Ansprüche, **dadurch gekennzeichnet, daß** auf die mindestens eine erste Halbleiterschicht (4) oder auf das Halbleitersubstrat (6) nachfolgend mindestens eine weitere GaN-, AIN-, AlGaN-, InN-, InGaN-, AlInN- oder AlInGaN -Schicht zur Herstellung dickerer GaN-, AIN-, AlGaN-, InN-, InGaN-, AlInN- oder AlInGaN -Schichten oder GaN-, AIN-, AlGaN-, InN-, InGaN-, AlInN- oder AIlnGaN -Einkristalle aufgebracht wird.

16. Verfahren nach Anspruch 15, **dadurch gekennzeichnet, daß** die GaN-, AIN-, AlGaN-, InN-, InGaN-, AlInN- oder AlInGaN -Schichten oder GaN-, AIN-, AlGaN-, InN-, InGaN-, AlInN- oder AlInGaN -Einkristalle nachfolgend durch Sägen vereinzelt werden.

17. Verfahren nach einem der vorhergehenden Ansprüche, **dadurch gekennzeichnet, daß** mindestens ein metallischer Kontakt zur Herstellung eines elektronischen oder optoelektronischen Bauelements aufgebracht wird.

18. Freistehendes Halbleitersubstrat (6) zur Herstellung elektronischer oder optoelektronischer Bauelemente, wobei das Halbleitersubstrat (6) mindestens einen Nitrid-Verbindungshalbleiter enthält, **dadurch gekennzeichnet, daß** das Halbleitersubstrat (6) Spuren von Wolframsilizidnitrid aufweist, wobei die Spuren von Wolframsilizidnitrid mindestens einer Konzentration von 10¹⁵ Atome je cm³ entsprechen.

19. Freistehendes Halbleitersubstrat (6) nach Anspruch 18, **dadurch gekennzeichnet, daß** die Spuren von Wolframsilizidnitrid im Bereich von weniger als 200 nm liegen.

20. Verwendung eines freistehenden Halbleitersubstrats (6) gemäß Anspruch 18 oder 19 zur Herstellung eines elektronischen oder optoelektronischen Bauelements.

21. Verwendung einer Maskenschicht, die zumindest teilweise aus Wolframsilizidnitrid besteht, in einem Verfahren gemäß Anspruch 1 zur Herstellung eines freistehenden, sich von einem Ausgangssubstrat selbstablösenden Halbleitersubstrats (6), das mindestens einen Nitrid-Verbindungshalbleiter enthält.

## Claims

1. Process for the manufacture of a semiconductor substrate (6), comprising the following process steps:
a) providing a starting substrate (1),
b) forming a mask layer (2) with a multitude of openings (3) on the starting substrate (1), wherein the mask layer is structured, either lithographically and opening of windows by wet- or dry-chemical etching processes, or by a lift-off process,
c) growing at least one semiconductor substrate (6) starting from the openings (3), wherein the mask layer (2) is laterally overgrown by at least one semiconductor material, and subsequently,
d) cooling of starting substrate (1), mask layer (2) and semiconductor substrate (6),
wherein the material for forming the mask layer (2) consists at least partially of tungsten silicide nitride or tungsten silicide, and a separation of semiconductor substrate (6) and starting substrate (1) occurs during the growth or during the cooling, and a semiconductor substrate (6) is obtained free-standing, wherein the semiconductor substrate (6) contains at least a nitride compound semiconductor.

2. Process according to claim 1, **characterized in that** the material for forming the mask layer (2) consists completely of tungsten silicide nitride or completely of tungsten silicide.

3. Process according to claim 1 or 2, **characterized in that** the free-standing semiconductor substrate (6) is formed by crack formation in the starting substrate (1) as well as in the regions of the semiconductor substrate (6) within the openings (3) of the mask (2) due to different thermal expansion coefficients of starting substrate (1) and the at least one semiconductor substrate (6) during the cooling, or due to the tensile stress of the grown semiconductor layer during the growth.

4. Process according to at least one of claims 1 to 3, **characterized in that** in step c), at least a first semiconductor layer (4) is grown as a coalescence layer, wherein the mask layer (2) is laterally overgrown by the semiconductor material (4), until a coherent layer is formed, such that the semiconductor substrate (6) consists of said at least one first semiconductor layer (4).

5. Process according to claim 4, **characterized in that** in step c) at least a second semiconductor layer (5) is grown onto the at least one first semiconductor layer (4), such that the semiconductor substrate (6) consists of the at least one first semiconductor layer (4) and the at least one second semiconductor layer (5).

6. Process according to claim 4, **characterized in that** the at least one first semiconductor layer (4) is grown with a thickness of 1 to 50 µm.

7. Process according to claim 5, **characterized in that** the at least one second semiconductor layer (5) is grown with a thickness of more than 100 µm.

8. Process according to one of the proceedings claims, **characterized in that**, prior to step b) at least one initial layer (1a), consisting of one or more individual layers, is grown over the whole area onto the starting substrate (1), and the mask layer (2) is formed on the at least one initial layer (1a).

9. Process according to one of the preceding claims 5, 7 or 8, **characterized in that** the at least one second semiconductor layer (5) and/or the at least one initial layer (1 a) contain at least a nitride compound semiconductor.

10. Process according to one of claims 4 to 9, **characterized in that** the at least one nitride compound semiconductor contained in the at least one first semiconductor layer (4) and/or contained in the at least one second semiconductor layer (5) and/or contained in the at least one initial layer (1 a) is a nitride compound of elements of the third and/or fifth main group.

11. Process according to claim 10, **characterized in that** the at least one nitride compound is GaN, AIN, AlGaN, InN, InGaN, AlInN or AlInGaN.

12. Process according to one of the preceding claims, **characterized in that** the at least one first semiconductor layer (4) is grown by means of hydride vapour phase epitaxy.

13. Process according to one of the claims being dependent from claims 8 to 10, **characterized in that** the at least one first semiconductor layer (4) is deposited by overgrowing the initial layer (1 a) by means of lateral epitaxial overgrowth (ELOG).

14. Process according to one of the preceding claims, **characterized in that** the at least one first semiconductor layer is grown such, that the islands growing out of the openings (3) coalesce, and a coherent surface is formed.

15. Process according to one of the preceding claims, **characterized in that**, on the at least one first semiconductor layer (4) or on the semiconductor substrate (6), subsequently at least one further GaN-, AIN-, AlGaN-, InN-, InGaN-, AlInN- or AlInGaN-layer is deposited for the manufacture of thicker GaN-, AIN-, AlGaN-, InN-, InGaN-, AlInN- or AlInGaN-layers or GaN-, AIN-, AlGaN-, InN-, InGaN-, AlInN- or AlInGaN-single crystals.

16. Process according to claim 15, **characterized in that** the GaN-, AIN-, AlGaN-, InN-, InGaN-, AlInN- or AlInGaN-layers or GaN-, AlN-, AIGaN-, InN-, InGaN-, AlInN- or AlInGaN-single crystals are subsequently individualized by sawing.

17. Process according to one of the preceding claims, **characterized in that** at least one metallic contact is placed for producing an electronic or opto-electronic device.

18. Free-standing semiconductor substrate (6) for the manufacture of electronic or opto-electronic devices, wherein the semiconductor substrate (6) contains at least one nitride compound semiconductor, **characterized in that** the semiconductor substrate (6) comprises traces of tungsten silicide nitride, wherein the traces of tungsten silicide nitride correspond to a concentration of at least 10¹⁵ atoms per cm³.

19. Free-standing semiconductor substrate (6) according to claim 18, **characterized in that** the traces of tungsten silicide nitride lie in the region of lower than 200 nm.

20. Use of the free-standing semiconductor substrate (6) according to claim 18 or 19 for producing an electronic or opto-electronic device.

21. Use of a mask layer at least partly consisting of tungsten silicide nitride in a process according to claim 1 for the manufacture of a free-standing semiconductor substrate (6) containing at least one nitride compound semiconductor, wherein the semiconductor substrate self-separates from the starting substrate.

## Revendications

1. Procédé de fabrication d'un substrat semi-conducteur (6), comportant les étapes suivantes :
a) préparation d'un substrat initial (1),
b) application d'une couche de masque (2) avec une pluralité d'orifices (3) sur le substrat initial (1), ladite couche de masque étant structurée, soit par lithographie et ouverture de fenêtres par procédé de gravure chimique par voie sèche ou humide, soit par procédé lift-off,
c) croissance d'au moins un substrat semi-conducteur (6) à partir des orifices (3), la couche de masque (2) subissant une surcroissance latérale par au moins un matériau semi-conducteur, et
d) refroidissement consécutif du substrat initial (1), de la couche de masque (2) et du substrat semi-conducteur (6),
le matériau de formation de la couche de masque (2) étant constitué au moins partiellement de nitrure de siliciure de tungstène ou de siliciure de tungstène, une séparation du substrat semi-conducteur (6) et du substrat initial (1) étant provoquée pendant la croissance ou pendant le refroidissement, et un substrat semi-conducteur isolé (6) étant obtenu, ledit substrat semi-conducteur (6) contenant au moins un semi-conducteur composé nitruré.

2. Procédé selon la revendication 1, **caractérisé en ce que** le matériau de formation de la couche de masque (2) est intégralement constitué de nitrure de siliciure de tungstène ou intégralement constitué de siliciure de tungstène.

3. Procédé selon la revendication 1 ou la revendication 2, **caractérisé en ce que** le substrat semi-conducteur isolé (6) est réalisé par fissuration dans le substrat initial (1) et dans les zones du substrat semi-conducteur (6) à l'intérieur des orifices (3) du masque (2), en raison des différents coefficients de dilatation thermique du substrat initial (1) et du ou des substrats semi-conducteur (6) pendant le refroidissement, ou en raison de la déformation sous tension de la couche semi-conductrice déposée pendant la croissance.

4. Procédé selon au moins une des revendications 1 à 3, **caractérisé en ce qu'**en étape c), au moins une première couche semi-conductrice (4) est déposée comme couche de coalescence, la couche de masque (2) subissant une surcroissance latérale par le matériau semi-conducteur (4), jusqu'à ce qu'une couche fermée se forme, si bien que le substrat semi-conducteur (6) est constitué de la ou des premières couches semi-conductrices (4).

5. Procédé selon la revendication 4, **caractérisé en ce qu'**en étape c), au moins une deuxième couche semi-conductrice (5) est déposée sur la ou les premières couches semi-conductrices (4), si bien que le substrat semi-conducteur (6) est constitué de la ou des premières couches semi-conductrices (4) et de la ou des deuxièmes couches semi-conductrices (5).

6. Procédé selon la revendication 4, **caractérisé en ce que** la ou les premières couches semi-conductrices (4) sont déposées avec une épaisseur comprise entre 1 et 50 µm.

7. Procédé selon la revendication 5, **caractérisé en ce que** la ou les deuxièmes couches semi-conductrices (5) sont déposées avec une épaisseur supérieure à 100 µm.

8. Procédé selon l'une des revendications précédentes, **caractérisé en ce qu'**avant l'étape b), au moins une couche initiale (1a), composée d'une ou de plusieurs couches individuelles, est déposée sur toute la surface du substrat initial (1), et la couche de masque (2) est appliquée sur la ou les couches initiales (1a).

9. Procédé selon l'une des revendications 5, 7 ou 8, **caractérisé en ce que** la ou les deuxièmes couches semi-conductrices (5) et/ou la ou les couches initiales (1a) contiennent au moins un semi-conducteur composé nitruré.

10. Procédé selon l'une des revendications 4 à 9, **caractérisé en ce que** le ou les semi-conducteurs composés nitrurés contenus dans la ou les premières couches semi-conductrices (4), dans la ou les deuxièmes couches semi-conductrices (5), dans la ou les couches initiales (1a) sont un ou des composés nitrurés d'éléments du troisième et/ou du cinquième groupe principal.

11. Procédé selon la revendication 10, **caractérisé en ce que** le ou les composés nitrurés sont GaN, AIN, AlGaN, InN, InGaN, AlInN ou AlInGaN.

12. Procédé selon l'une des revendications précédentes, **caractérisé en ce que** la ou les premières couches semi-conductrices (4) sont déposées par épitaxie en phase vapeur aux hydrures.

13. Procédé selon une revendication dépendante des revendications 8 à 10, **caractérisé en ce que** la ou les premières couches semi-conductrices (4) sont appliquées par surcroissance de la couche initiale (1 a) au moyen d'une recroissance épitaxiale latérale (ELOG).

14. Procédé selon l'une des revendications précédentes, **caractérisé en ce que** la ou les premières couches semi-conductrices sont déposées de telle manière que les îlots croissant à partir des orifices (3) sont coalescés et qu'une surface fermée s'est constituée.

15. Procédé selon l'une des revendications précédentes, **caractérisé en ce qu'**au moins une autre couche GaN, AIN, AlGaN, InN, InGaN, AlInN ou AlInGaN est appliquée consécutivement sur la ou les premières couches semi-conductrices (4) ou sur le substrat semi-conducteur (6) pour la production de couches GaN, AIN, AlGaN, InN, InGaN, AlInN ou AlInGaN plus épaisses ou de monocristaux GaN, AIN, AlGaN, InN, InGaN, AlInN ou AlInGaN.

16. Procédé selon la revendication 15, **caractérisé en ce que** les couches GaN, AIN, AlGaN, InN, InGaN, AlInN ou les monocristaux AlInGaN ou GaN, AIN, AlGaN, InN, InGaN, AlInN ou AlInGaN sont séparés consécutivement par sciage.

17. Procédé selon l'une des revendications précédentes, **caractérisé en ce qu'**au moins un contact métallique est appliqué pour former un composant électronique ou optoélectronique.

18. Substrat semi-conducteur isolé (6) pour la fabrication de composants électroniques ou optoélectroniques, ledit substrat semi-conducteur (6) contenant au moins un semi-conducteur composé nitruré, **caractérisé en ce que** ledit substrat semi-conducteur (6) présente des traces de nitrure de siliciure de tungstène, lesdites traces de nitrure de siliciure de tungstène correspondant au moins à une concentration de 10¹⁵ atomes par cm³.

19. Substrat semi-conducteur isolé (6) selon la revendication 18, **caractérisé en ce que** les traces de nitrure de siliciure de tungstène sont dans la plage inférieure à 200 nm.

20. Utilisation d'un substrat semi-conducteur isolé (6) selon la revendication 18 ou la revendication 19 pour fabriquer un composant électronique ou optoélectronique.

21. Utilisation d'une couche de masque composée au moins partiellement de nitrure de siliciure de tungstène suivant un procédé selon la revendication 1, pour la fabrication d'un substrat semi-conducteur isolé (6) se détachant spontanément d'un substrat initial et qui contient au moins un semi-conducteur composé nitruré.
